(19) Europäisches Patentamt
European Patent Office
Office européen des brevets

(11) **EP 2 557 467 A2**

(12) **EUROPÄISCHE PATENTANMELDUNG**

(43) Veröffentlichungstag:
**13.02.2013 Patentblatt 2013/07**

(51) Int Cl.:
***G05B 23/02*** *(2006.01)*  ***B64C 13/00*** *(2006.01)*

(21) Anmeldenummer: **12191846.0**

(22) Anmeldetag: **28.04.2010**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.04.2009 DE 102009002682**
**28.04.2009 US 173239 P**

(62) Dokumentnummer(n) der früheren Anmeldung(en) nach Art. 76 EPÜ:
**10717620.8 / 2 425 308**

(71) Anmelder: **Airbus Operations GmbH**
**21129 Hamburg (DE)**

(72) Erfinder:
• **Gojny, Marcus**
**21029 Hamburg (DE)**

• **Carl, Udo B.**
**21077 Hamburg (DE)**
• **Sachs, Helge**
**22761 Hamburg (DE)**

(74) Vertreter: **Isarpatent**
**Patent- und Rechtsanwälte**
**Friedrichstrasse 31**
**80801 München (DE)**

Bemerkungen:
Diese Anmeldung ist am 08-11-2012 als Teilanmeldung zu der unter INID-Code 62 erwähnten Anmeldung eingereicht worden.

(54) **Einrichtung und Verfahren zur Residuenauswertung eines Residuums zur Erkennung von Systemfehlern im Systemverhalten eines Systems eines Flugzeugs**

(57) Die vorliegende Erfindung schafft eine Einrichtung und ein Verfahren zur Residuenauswertung eines Residuums zur Erkennung von Systemfehlern im Systemverhalten eines Systems eines Flugzeugs.

Die Einrichtung zur Residuenauswertung hat eine Vorrichtung zur Residuengenerierung des Residuums zumindest in Abhängigkeit der Führungsgröße und der System-Ausgangsgröße, eine Komparator-Einheit zur Bereitstellung eines Auswerte-Ergebnisses mittels eines Vergleichs des Residuums mit einem bereitgestellten Schwellwert, eine erste Einheit zur Bereitstellung eines konstanten Schwellwertanteils, eine zweite Einheit zur Bereitstellung eines adaptiven Schwellwertanteils zumindest in Abhängigkeit der zeitlich veränderlichen Führungsgröße und eine dritte Einheit zur Bereitstellung des Schwellwertes mittels einer Verknüpfung des konstanten Schwellwertanteils mit dem adaptiven Schwellwertanteil.

Fig. 3

EP 2 557 467 A2

**Beschreibung**

Die vorliegende Erfindung betrifft eine Einrichtung und ein Verfahren zur Residuenauswertung eines Residuums zur Erkennung von Systemfehlern im Systemverhalten eines Systems eines Flugzeugs.

Das technische Gebiet der Erfindung betrifft die Auswertung eines generierten Residuums zur Erkennung von Systemfehlern, insbesondere von fehlerhaften Transienten, Drift oder Oszillationen, im Systemverhalten eines Systems eines Flugzeuges, beispielsweise eines elektrohydraulischen Ruderstellsystems.

Überschreitet das generierte Residuum eine vorbestimmte Schwelle oder Schranke, so ist ein Fehler im Systemverhalten detektiert. Solche Systemfehler im Systemverhalten zeigen sich in Form von fehlerhaften Transienten, Drift oder Oszillationen im Eingangs-/Ausgangsverhalten des Systems.

Dabei zieht die zunehmende Komplexität von Flugzeugsteuerungssystemen, insbesondere digitale Flugzeugsteuerungssysteme, die bei größtmöglicher Redundanz vor allem verbesserte Flugeigenschaften sowie eine Vielzahl an Sicherungsfunktionen und Komfortfunktionen ermöglichen, das vermehrte Auftreten zum Teil neuer Fehlerszenarien nach sich. Dazu zählen insbesondere nahezu ungedämpfte Stellflächenoszillationen der Stellflächen. Von besonderer Bedeutung sind dabei die OFC-Ursachen (OFC, Oscillatory Failure Case), welche durch Fehler im Stellsystem selbst auftreten oder sich aus den Flugsteuerungsrechnern oder der zur Erfassung der flugmechanischen Eigenbewegung vorgelagerten Sensorik in die Aktuatorregelkreise der jeweiligen Stellsysteme fortpflanzen.

Die Vielzahl der denkbaren OFC-Szenarien umfasst dabei Fehler in Komponenten der Datenverarbeitung und der Signalverarbeitung, Softwarefehler, mechanische Defekte, beispielsweise in der Servoventilbaugruppe, oder Ausfälle von elektronischen Einzelbausteinen auf unterster Schaltkreisebene, zum Beispiel im Spannungs-Strom-Wandler.

Weitere Fehlerszenarien können sich aus Wechselwirkungen zwischen den einzelnen Systemkomponenten des Aktuatorregelkreises oder des digitalen Flugsteuerungssystems ergeben.

Zur Detektion von solchen Systemfehlern ist im Rahmen eines modellbasierten Diagnoseansatzes die Generierung des Residuums zur Identifikation einer fehlerbedingten Abweichung des Realsystemverhaltens vom nominalen, fehlerfreien Systemverhalten erforderlich. Dazu zeigt die Druckschrift US 2007/0124038 A1 eine Lösung mittels einer Anwendung eines Parallelmodells zur Schätzung einer Kolbenposition des Ruderstellsystems des Flugzeuges, welche über eine kinematische Beziehung der Position der Stellfläche entspricht.

Zur Schätzung der Kolbenposition des realen, elektrohydraulischen Ruderstellsystems ist der Ansatz eines detaillierten, nicht linearen oder eines vereinfachten linearen Parallelmodells vorgesehen, welcher in der Fig. 2 der US 2007/0124038 A1 abgebildet ist. Dabei zeigt die mit dem Bezugszeichen 19 der Fig. 2 versehene Einheit das Parallelmodell, welches die detaillierte, nichtlineare Abbildung der realen Systemdynamik oder eine vereinfachte lineare Beschreibung beinhaltet. Als einziges Eingangssignal für das Parallelmodell 19 ist die zeitlich veränderliche Führungsvorgabe - bezeichnet mit dem Bezugszeichen 20 - für den Aktuatorregelkreis vorgesehen, welche vom Flugsteuerungsrechner eingeprägt wird. Das einzige Ausgangssignal des Parallelmodells 19 ist mit dem Bezugszeichen 29 bezeichnet und beschreibt die geschätzte zeitlich veränderliche Aktuatorkolbenposition.

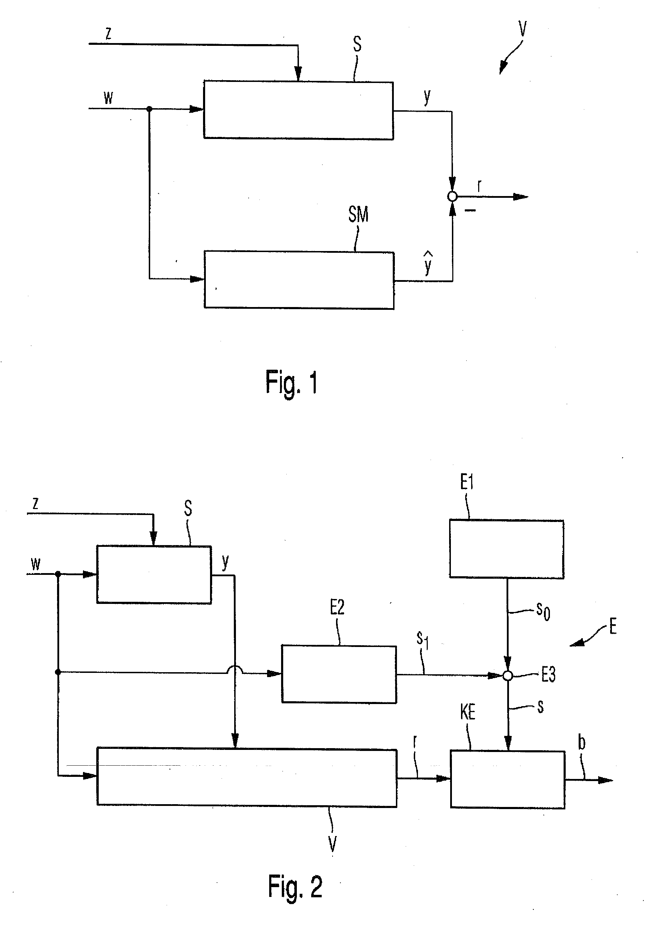

In diesem Zusammenhang zeigt die Fig. 1 der vorliegenden Anmeldung ein schematisches Blockschaltbild einer herkömmlichen Vorrichtung V zur Generierung eines Residuums r.

Dabei entspricht die herkömmliche Vorrichtung V nach Fig. 1 einer verallgemeinerten Darstellung der Fig. 4 der US 2007/0124038 A1, um die auftretenden Nachteile des Standes der Technik besser darstellen zu können.

Mit Bezug auf Fig. 1 bezeichnet das Bezugszeichen z eine Störgröße, die externe Störungen auf das System S abbildet.

Das System S hat als Eingangsgröße die Führungsgröße w und stellt ausgangsseitig die System-Ausgangsgröße y bereit. Das System S ist beispielsweise ein reales elektrohydraulisches Ruderstellsystem und die System-Ausgangsgröße y entspricht einer gemessenen Verschiebung des Aktuatorkolbens des Ruderstellsystems. Zur Bereitstellung einer geschätzten System-Ausgangsgröße $\hat{y}$ ist parallel zu dem System S ein Systemmodell SM angeordnet.

Der Kern des in der US 2007/0124038 A1 beschriebenen Schätzverfahrens besteht im Wesentlichen aus dem parallelen System-modell oder Prozessmodell, welches in Form einer mathematischen Beschreibung die Anfangswerte des Prozesses oder Systems und seine Parametrisierung bestmöglich approximiert. Das identische Eingangssignal für das System S, die Führungsgröße oder Führungsvorgabe w, ist das einzige Eingangssignals des Systemmodells SM. Gemäß der gewählten Anfangswerte und der parametrisierten Systemdynamik des definierten Systemmodells ergibt sich die geschätzte System-Ausgangsgröße $\hat{y}$ des Systemmodells SM. Zur Generierung des Residuums r wird die Differenz zwischen dem zeitlich veränderlichen Systemausgangssignal y und dem geschätzten Systemausgangssignal $\hat{y}$ des System-modells SM gebildet. Das Residuum r wird im Fall eines Überschreitens eines vordefinierten Schwellwertes zur Identifikation eines Systemfehlers verwendet.

Bei der Anwendung der in Fig. 1 skizzierten und aus der US 2007/0124038 A1 bekannten Lösung auf die spezifische Aufgabe der Erkennung von fehlerhaften Oszillationen, Drift und Transienten eines elektrohydraulischen Ruderstellsystems können folgende Probleme auftreten: Die Einstellung eines robusten und dennoch hochempfindlichen Detektionsschwellwertes für das Residuum r gelingt nicht ausreichend, da externe Störungen - bezeichnet mit dem Bezugzeichen z - auftreten können, die auf das System S wirken, aber vom Systemmodell SM nicht abgebildet werden. Diese externen Störungen ergeben sich bei einem elektrohydraulischen Ruderstellsystem insbesondere aus Luftkräften, die auf die angetriebene Stellfläche während des Fluges wirken und das Stellsystem mechanisch belasten, zum Beispiel durch transiente Strömungen durch einmalige Ereignisse wie Böen, harmonische Störungen durch periodische Wirbelablösungen oder Effekte aus der Flexibilität der umgebenden Struktur oder stochastische Störungen, insbesondere als Prozessrauschen aufgrund der aerodynamischen Wirkung von Turbulenzen. Ein weiterer Grund für die unzureichende Möglichkeit der Einstellung des Detektionsschwellwertes liegt in der permanenten Überlagerung der gemessenen Aktuatorposition als System-Ausgangsgröße y mit Messrauschen aufgrund der instrumentierten Sensorausstattung, beispielsweise der Positionsaufnehmer an der Aktuatorkolbenstange.

Weiter haben hochdynamische Veränderungen der Führungsgröße w unter Anwesenheit von Störungen ein sehr rasches, kurzfristiges Anwachsen des Residuums r zur Folge.

Des Weiteren verändert sich der Prozess oder das System S durch Änderungen von Parametern oder Randbedingungen, beispielsweise Fluggeschwindigkeit, Flughöhe, Anstell- und Schiebewinkel, Temperatur, Eigenschaften des hydraulischen Mediums des Aktuators und dergleichen, während des Betriebes oder Fluges. Diese Veränderungen wirken auf das Antwortverhalten des Systems S und damit auf die Eigendynamik des Systems S. Sie werden vom parallelen Prozessmodell oder System-modell SM nicht abgebildet.

Weiterhin können die Anfangswerte des Prozesses oder Systems S in praktischen Anwendungen lediglich durch ein Modell approximiert werden. Derart initiierte Abweichungen in der Systemantwort des Systemmodells SM sowie die Wirkung vernachlässigter und unbekannter Dynamik bleiben bei der aus der US 2007/0124038 A1 bekannten Lösung unkorrigiert.

Dies führt nachteiligerweise zu einem Signalanteil im Residuum, welcher eine sehr empfindliche Einstellung des Schwellwertes zur Fehlerdetektion ohne Einschränkung des überwachten Frequenzbandes ohne zusätzliche Maßnahmen erheblich erschwert.

In der US 2007/0124038 A1 (Fig. 2) ist zur Residuengenerierung durch Bildung des Differenzwertes zwischen den zeitveränderlichen Größen der gemessenen Aktuatorkolbenposition 22 und der Ausgangsgröße 29 des Parallelmodells der Subtrahierer 21 vorgesehen. Dessen Ausgangssignal 24 entspricht dem gebildeten Residuum. Weiter zeigt die mit Bezugzeichen 23 versehene Einheit ein Auswertemodul zur Auswertung des Residuums zur Fehlerdetektion.

Das Auswertemodul 23 vergleicht das Residuum 24 mit einem vordefinierten Schwellwert und zählt jede Überschreitung dieses Schwellwertes. Nach einer vorbestimmten Anzahl von gezählten Überschreitungen des vorbestimmten Schwellwertes wird ein oszillatorischer Fehlerfall festgestellt und ein Ausgangssignal 26 wird auf einen positiven logischen Wert zur Anzeige dieses Fehlers gesetzt.

Um eine gewisse Güte des Auswertemoduls 23 zu erreichen, besteht dieses aus einer seriellen Verknüpfung einer frequenzselektiven Filterbank, Einheit mit dem Bezugzeichen 27, und einer nachgeschalteten Komparatorstufe, Einheit mit dem Bezugzeichen 25, für jedes einzelne Frequenzband des Residuums 24. Die frequenzselektive Filterbank 27 besteht aus einer Parallelschaltung von Bandpassfiltern zur spektralen Trennung des Residuums 24 in vorbestimmte Frequenzbänder. Dabei bezeichnet das Bezugzeichen 28 einen Vektor der spektralen Anteile des Residuums 24 in den durch die frequenzselektive Filterbank 27 festgelegten Frequenzbändern.

Dazu umfasst die Komparatorbank 25 jeweils einen gesonderten Kanal für jede Komponente des Vektors 28, in welchem die jeweilige Komponente mit einem vordefinierten Schwellwert verglichen wird. In jedem Kanal wird der Fall der Überschreitung mittels eines Zählers vermerkt. Übersteigt die Anzahl der gezählten Überschreitungen eines Kanals eine vorab bestimmte Schranke, wird der oszillatorische Fehlerfall festgestellt und mittels des Ausgangssignals 28 angezeigt.

Bei der Anwendung dieser aus der US 2007/0124038 A1 bekannten Lösung auf die spezifische Aufgabe der Erkennung von Systemfehlern eines elektrohydraulischen Ruderstellsystems eines Flugzeuges können folgende Probleme auftreten: Die Einstellung eines robusten und dennoch hochempfindlichen Detektionsschwellwertes für das Residuum gelingt nicht ausreichend, und somit wird lediglich eine beschränkte Güte für die Überwachungsfunktion des Ruderstellsystems erreicht. Ein Grund hierfür ist unter anderem, dass hochdynamische Veränderungen der Führungsgröße oder Führungsvorgabe unter Anwesenheit von Störungen stets ein sehr rasches und kurzfristiges Anwachsen des Residuums bedingen. Diese können insbesondere durch den Betrieb in turbulenter Atmosphäre, durch Antwortverhalten flexibler Strukturen oder periodische Wirbelablösungen entstehen. Des Weiteren kann inhärentes Messrauschen des Systems diese nachteiligen Effekte zusätzlich verstärken. Um in den jeweiligen zugeordneten Frequenzbändern keine fortwährenden Fehlalarme auszulösen, müssen die Detektionsschwellenwerte entsprechend angehoben werden, und gegebenenfalls muss die Anzahl der erforderlichen Bestätigungszyklen erhöht werden. Dies hat für die Erkennung von Dauerschwingungen infolge von Systemfehlern eine stark verringerte Empfindlichkeit und weiter eine gesteigerte Erkennungszeit des Auswertemoduls zur Folge. Dies trifft insbesondere auf solche Systemfehler zu, bei denen sich ein oszillierender Anteil mit einem nominalen Systemausgangssignal niedriger Frequenz überlagert.

Ein weiterer Grund für die beschränkte Güte für die Überwachungsfunktion des Ruderstellsystems liegt im Übersprechen zwischen benachbarten Frequenzbereichen, da eine exakte Trennung technisch schwer realisierbar ist. Ein solches Übersprechen kann im Falle unterschiedlicher Schwellwerte vermehrt Fehlalarme auslösen.

Des Weiteren kann sich insbesondere aus dem strukturdynamischen Antwortverhalten eine Unsicherheit für die Festlegung der Grenzen der höheren Frequenzbänder in Kombination mit korrespondierenden festen Schwellwerten ergeben. Dies hat einen unmittelbaren nachteiligen Einfluss auf die zu erzielende Güte bei der Fehlererkennung im höheren Frequenzbereich. Durch die Anwendung der aus der US 2007/0124038 A1 bekannten Zählmethode ist die Fehlererkennung auf die Erkennung oszillatorischer Stellsystemfehler beschränkt. Die Möglichkeit einer Erweiterung auf andere Fehlerszenarien, wie Transienten oder Kriechen, sind methodisch grundsätzlich ausgeschlossen. Dieses macht für Monitorkonzepte moderner Stellsysteme nachteiligerweise eine parallele Aufstellung und Instrumentierung verschiedener spezifischer Einrichtungen zur Fehlererkennung erforderlich. Insgesamt erschwert die in der US 2007/0124038 A1 vorgeschlagene Anordnung zur Residuenauswertung eine empfindliche Einstellung des Schwellwertes zur breitbandigen Fehlerdetektion ohne Einschränkung des überwachten Frequenzbandes erheblich.

Demnach ist es eine Aufgabe der vorliegenden Erfindung, eine Residuenauswertung eines Residuums zur Erkennung von Systemfehlern, insbesondere von fehlerhaften Transienten, Drift oder Oszillationen, im Systemverhalten eines Systems eines Flugzeugs zu schaffen, welche die oben beschriebenen Nachteile nicht aufweist.

Erfindungsgemäß wird diese Aufgabe durch eine Einrichtung mit den Merkmalen des Patentanspruchs 1 und/oder durch ein Verfahren mit den Merkmalen des Patentanspruchs 14 gelöst.

Demgemäß wird eine Einrichtung zur Residuenauswertung eines Residuums zur Erkennung von Systemfehlern eines Systems vorgeschlagen, welches eine zeitlich veränderliche Führungsgröße und eine externe Störungen abbildende Störgröße eingangsseitig empfängt und ausgangsseitig eine System-Ausgangsgröße bereitstellt, wobei die Einrichtung aufweist:

- eine Vorrichtung zur Residuengenerierung des Residuums zumindest in Abhängigkeit der Führungsgröße und der System-Ausgangsgröße;
- eine Komparator-Einheit zur Bereitstellung eines Auswerte-Ergebnisses mittels eines Vergleichs des Residuums mit einem bereitgestellten Schwellwert;
- eine erste Einheit zur Bereitstellung eines konstanten Schwellwertanteils;
- eine zweite Einheit zur Bereitstellung eines adaptiven Schwellwertanteils zumindest in Abhängigkeit der zeitlich veränderlichen Führungsgröße; und
- eine dritte Einheit zur Bereitstellung des Schwellwertes mittels einer Verknüpfung des konstanten Schwellwertanteils mit dem adaptiven Schwellwertanteil.

Die jeweilige Einheit, die erste bis dritte Einheit sowie die Komparator-Einheit, kann hardwaretechnisch oder auch softwaretechnisch implementiert sein. Bei einer hardwaretechnischen Implementierung kann die jeweilige Einheit als Vorrichtung, zum Bespiel als Computer oder Mikroprozessor, Einrichtung oder auch als Teil eines Systems, zum Bespiel als Computer-System, ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Des Weiteren wird ein Flugzeug mit zumindest einer wie oben beschriebenen Einrichtung vorgeschlagen.

Weiterhin wird ein Verfahren zur Residuenauswertung eines Residuums zur Erkennung von Systemfehlern im Systemverhalten eines Systems vorgeschlagen, wobei das System eine zeitlich veränderliche Führungsgröße und eine externe Störungen abbildende Störgröße eingangsseitig empfängt und ausgangsseitig eine System-Ausgangsgröße bereitstellt, wobei das Verfahren folgende Schritte hat:

- Generieren eines Residuums zumindest in Abhängigkeit der Führungsgröße und der System-Ausgangsgröße;
- Bereitstellen eines konstanten Schwellwertanteils;
- Bereitstellen eines adaptiven Schwellwertanteils zumindest in Abhängigkeit der zeitlich veränderlichen Führungsgröße;
- Bereitstellen eines Schwellwertes mittels einer Verknüpfung des konstanten Schwellwertanteils mit dem adaptiven Schwellwertanteil ; und
- Vergleichen des Residuums mit dem bereitgestellten Schwellwert zur Bereitstellung eines Auswerte-Ergebnisses.

Ferner wird ein Computerprogrammprodukt vorgeschlagen, welches auf einer programmgesteuerten Einrichtung die Durchführung eines wie oben beschriebenen Verfahrens zur Residuenauswertung eines Residuums zur Erkennung von Systemfehlern im Systemverhalten eines Systems veranlasst.

Ein Vorteil der vorliegenden Erfindung liegt in der robusten Auswertung eines Residuums, mittels welchem das Vorliegen von Systemfehlern, insbesondere von fehlerhaften Transienten, Kriechen, Dauerschwingungen oder Oszillationen, in einem System eines Flugzeuges, insbesondere eines elektrohydraulischen Ruderstellsystems, detektierbar ist.

Dabei ist erfindungsgemäß die Erkennung von vorstehend bezeichneten Systemfehlern und insbesondere die Vermeidung von falschen Anzeigen durch den erfindungsgemäßen Einsatz des adaptiven Detektionsschwellwertes sehr robust möglich.

Diese Güte ist in Tests mit realen Ruderstellsystemen Hardware-In-The-Loop nachgewiesen, deren Ergebnisse in Sachs, Helge: "Fault Investigation and Robust Failure Detection of Oscillatory Aircraft Actuation Systems Using Analytical Redundancy", Hamburg, Hamburg University of Technology, Aircraft Systems Engineering M-7, PhD thesis, offenbart sind.

Dabei werden erfindungsgemäß hochdynamische Veränderungen der Führungsvorgabe oder Führungsgröße unmittelbar über die Schwellwertanpassung mittels des adaptiven Schwellwertanteils abgebildet. Auf diese Weise werden auch dynamische Systemantworten auf Störungen erfasst, welche im Betrieb in turbulenter Atmosphäre, durch Antwortverhalten flexibler Strukturen oder periodische Wirbelablösungen entstehen können. Insbesondere gelingt dabei erfindungsgemäß die sichere und schnelle Erkennung von Systemfehlern, bei denen sich ein oszillierender Anteil mit einem nominellen Systemausgangssignal niedriger Frequenz überlagert.

Des Weiteren wird das zu erwartende, inhärente Messrauschen des Systems durch den konstanten Schwellwertanteil getrennt berücksichtigt, der vorzugsweise auf einen minimalen Wert eingestellt ist.

Durch die direkte Verarbeitung des Einflusses der zeitlich veränderlichen Führungsvorgabe ist es erfindungsgemäß nicht mehr erforderlich, die sich aus dem Nominalbetrieb ergebenden Amplituden durch die Detektionsschwellwerte abzubilden. Für resultierende Fehleramplituden kann auf dieses Weise stets eine nur durch die Prozessinstrumentierung beschränkte, minimale Fehlerschwelle über den gesamten Spektralbereich angewendet werden.

Zusätzlich ist es durch die Elimination der aus der US 2007/0124038 A1 bekannten Zählmethode erfindungsgemäß möglich, die Bestätigungszeiten erheblich zu reduzieren bzw. auf Null zu setzen. Insbesondere bei Fehlerzuständen mit Dauerschwingungen größerer Periodendauern sinkt auf diese Weise die gesamte Erkennungszeit erheblich.

Weiterhin ermöglicht die Elimination der herkömmlichen Zählmethode die Erkennung von Systemfehlern, welche nicht zu Schwingungen insbesondere der Aktuatorkolbenposition bzw. Stellfläche führen. Folglich können auch Systemfehler infolge von Transienten und Kriechen detektiert werden. Damit kann die Instrumentierung verschiedener spezifischer Einrichtungen zur Fehlererkennung deutlich reduziert werden.

In den Unteransprüchen finden sich vorteilhafte Ausgestaltungen und Verbesserungen der Erfindung.

Gemäß einer bevorzugten Weiterbildung ist die erste Einheit dazu eingerichtet, den konstanten Schwellwertanteil in Abhängigkeit eines zu erwartenden, inhärenten Messrauschens des Systems bereitzustellen.

Gemäß einer weiteren bevorzugten Weiterbildung ist die erste Einheit dazu eingerichtet ist, den konstanten Schwellwertanteil in Abhängigkeit des zu erwartenden, inhärenten Messrauschens des Systems auf einen minimalen Wert einzustellen.

Gemäß einer weiteren bevorzugten Weiterbildung hat die Vorrichtung zur Residuengenerierung des Residuums zumindest ein Systemmodell zur Abbildung des zu überwachenden Systems.

Gemäß einer weiteren bevorzugten Weiterbildung hat die Vorrichtung zur Residuengenerierung des Residuums:

- ein erstes Mittel mit einem System-Modell zur Abbildung des zu überwachenden Systems, welches eingangsseitig die Führungsgröße, eine Beobachterrückführgröße und eine Störmodellgröße empfängt und abhängig davon ausgangsseitig eine geschätzte System-Ausgangsgröße bereitstellt;
- ein zweites Mittel zur Bildung eines Residuums aus der Differenz zwischen der System-Ausgangsgröße und der geschätzten System-Ausgangsgröße;
- ein drittes Mittel mit einer Beobachter-Rückführung, welche eingangsseitig das Residuum empfängt und abhängig davon ausgangsseitig die Beobachterrückführgröße zur dynamischen Korrektur des Systemmodells derart bereitstellt, dass die geschätzte System-Ausgangsgröße der System-Ausgangsgröße folgt; und
- ein viertes Mittel mit einem Störmodell, welches eingangsseitig das Residuum empfängt und abhängig davon ausgangsseitig die Störmodellgröße zur Abbildung der Wirkungen der externen Störungen auf das System-Modell bereitstellt.

Bei der Verbindung des Konzeptes zur Generierung des adaptiven Schwellwertes in Kombination mit dem reduzierten Störbeobachter ist in Tests mit realen Ruderstellsystemen Hardware-In-The-Loop nachgewiesen, dass die Steigerung der Güte der Fehlererkennung hierdurch erheblich ist. Dabei ist die Sensitivität durch Senkung der Detektionsschwellen um 55 bis 90% gesteigert. Weiterhin ist die Zeit für eine Rekonfiguration des Systems nach einem Powered-Runaway-Ereignis, das heißt die Stellfläche läuft unkontrolliert mit maximaler Geschwindigkeit in ihre Endlage, nur 1/15 des gesamten, für die Rekonfiguration vorgegebenen Zeitintervalls. Weiter sind resultierende dynamische Strukturbelastungen deutlich verringert.

Gemäß einer weiteren bevorzugten Weiterbildung ist die zweite Einheit dazu eingerichtet, den adaptiven Schwellwertanteil in Abhängigkeit der zeitveränderlichen Führungsgröße und zumindest einer mittels des Systemmodells geschätzten Zustandsgröße bereitzustellen.

Gemäß einer weiteren bevorzugten Weiterbildung ist die zweite Einheit dazu eingerichtet, den adaptiven Schwellwert in Abhängigkeit der zeitveränderlichen Führungsgröße und zumindest einer bereitgestellten Messgröße des Systems und/oder zumindest einer mittels des Systemmodells geschätzten Zustandsgröße bereitzustellen.

Gemäß einer weiteren bevorzugten Weiterbildung ist die dritte Einheit dazu eingerichtet, den konstanten Schwellwertanteil mit dem adaptiven Schwellwertanteil zur Bereitstellung des Schwellwertes zu addieren.

Gemäß einer weiteren bevorzugten Weiterbildung setzt die Komparator-Einheit das Auswerte-Ergebnis zur Anzeige eines Systemfehlers auf einen positiven logischen Wert, falls das bereitgestellte Residuum größer als der bereitgestellte Schwellwert ist.

Gemäß einer weiteren bevorzugten Weiterbildung ist eine vierte Einheit vorgesehen, welche die Komparator-Einheit nach Ablauf einer vorbestimmten Bestätigungszeit aktiviert.

Gemäß einer weiteren bevorzugten Weiterbildung ist ein Systemfehler als ein fehlerhafter Transient, als Drift oder als eine Oszillation ausgebildet.

Die Erfindung wird im Folgenden anhand von Ausführungsbeispielen unter Bezugnahme auf die beiliegenden Figuren der Zeichnung näher erläutert.

Von den Figuren zeigen:

Fig. 1      ein schematisches Blockschaltbild eines Ausführungsbeispiels einer herkömmlichen Vorrichtung zur Residuengenerierung zur Erkennung von Systemfehlern eines Systems eines Flugzeugs;

Fig. 2      ein schematisches Blockschaltbild eines ersten Ausführungsbeispiels einer Einrichtung zur Residuenauswertung eines Residuums zur Erkennung von Systemfehlern im Systemverhalten eines Systems eines Flugzeugs;

Fig. 3      ein schematisches Blockschaltbild eines zweiten Ausführungsbeispiels einer Einrichtung zur Residuenauswertung eines Residuums zur Erkennung von Systemfehlern im Systemverhalten eines Systems eines Flugzeugs;

Fig. 4      ein schematisches Blockschaltbild eines ersten Ausführungsbeispiels einer Vorrichtung zur Residuengenerierung zur Erkennung von Systemfehlern im Systemverhalten eines Systems eines Flugzeugs;

Fig. 5      ein schematisches Blockschaltbild eines zweiten Ausführungsbeispiels einer Vorrichtung zur Residuengenerierung zur Erkennung von Systemfehlern im Systemverhalten eines Systems eines Flugzeugs;

Fig. 6      ein schematisches Ablaufdiagramm eines Ausführungsbeispiels eines Verfahrens zur Residuenauswertung eines Residuums zur Erkennung von Systemfehlern im Systemverhalten eines Systems eines Flugzeugs;

Fig. 7      ein schematisches Ablaufdiagramm eines Ausführungsbeispiels eines Verfahrens zur Residuengenerierung zur Erkennung von Systemfehlern im Systemverhalten eines Systems eines Flugzeugs; und

Fig. 8-12      schematische Zeitdiagramme zur Illustrierung der erfindungsgemäßen Residuenauswertung eines Residuums zur Erkennung von Systemfehlern im Systemverhalten eines Systems eines Flugzeuges.

In den Figuren bezeichnen dieselben Bezugszeichen gleiche oder funktionsgleiche Komponenten, soweit nichts Gegenteiliges angegeben ist.

Fig. 2 zeigt ein schematisches Blockschaltbild eines ersten Ausführungsbeispiels einer Einrichtung E zur Residuenauswertung eines Residuums r zur Erkennung von Systemfehlern im Systemverhalten eines Systems S eines Flugzeuges. Das System S empfängt eingangsseitig eine zeitlich veränderlich Führungsgröße w und eine externe Störungen abbildende Störgröße z. Abhängig davon stellt das System S ausgangsseitig eine System-Ausgangsgröße y bereit. Die Einrichtung E zur Residuenauswertung hat zumindest eine Vorrichtung V zur Residuengenerierung des Residuums r, eine Komparator-Einheit KE, eine erste Einheit E1, eine zweite Einheit E2 und eine dritte Einheit E3.

Die Vorrichtung V ist zur Residuengenerierung des Residuums r geeignet, wobei die Vorrichtung V das Residuum r zumindest in Abhängigkeit der Führungsgröße w und der System-Ausgangsgröße y generiert.

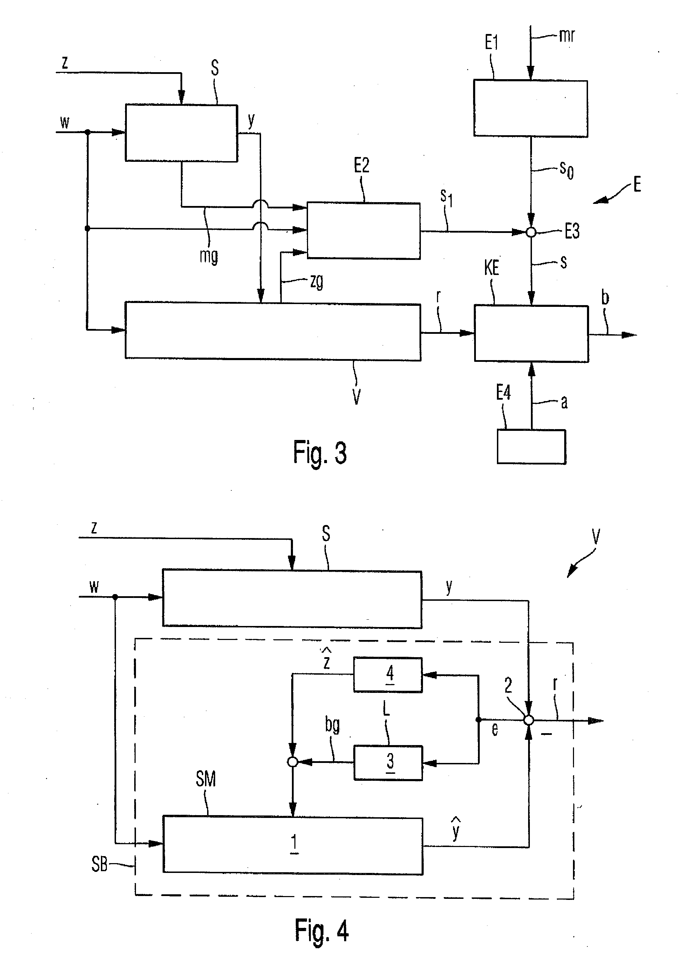

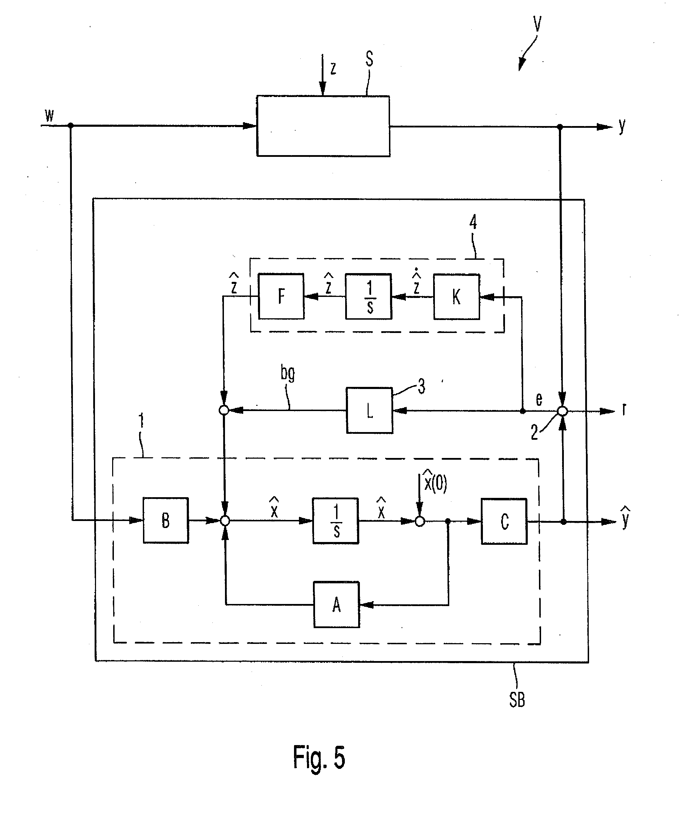

Die Vorrichtung V ist beispielsweise nach einem der Ausführungsbeispiele der Figuren 4 oder 5 ausgebildet.

Die Komparator-Einheit KE stellt ein Auswerte-Ergebnis b mittels eines Vergleichs des Residuums r mit einem bereitgestellten Schwellenwert s bereit.

Zur Bereitstellung des Schwellenwertes s sind die Einheiten E1 bis E3 vorgesehen.

Dabei ist die erste Einheit E1 dazu eingerichtet, einen konstanten Schwellwertanteil s0 bereitzustellen.

Die zweite Einheit E2 ist dazu eingerichtet, einen adaptiven Schwellwertanteil s1 zumindest in Abhängigkeit der zeitlich veränderlichen Führungsgröße w bereitzustellen.

Ferner ist die dritte Einheit E3 dazu eingerichtet, den Schwellwert s mittels einer Verknüpfung des konstanten Schwellwertanteils s0 mit dem adaptiven Schwellwertanteil s1 bereitzustellen. Insbesondere addiert die dritte Einheit E3 den konstanten Schwellwert S0 mit dem adaptiven Schwellwert s1 zur Ausbildung des Schwellwertes s.

Die Komparator-Einheit KE setzt das Auswerte-Ergebnis b zur Anzeige eines Systemfehlers auf einen positiven logischen Wert, falls das bereitgestellte Residuum r größer als der bereitgestellte Schwellwert s ist. Alternativ kann das Auswerte-Ergebnis b auch als ein Signal, beispielsweise als ein kontinuierliches Signal, ausgebildet sein, das dazu eingerichtet ist, die beiden möglichen Zustände (r > s und r ≤ s) anzuzeigen.

Fig. 3 zeigt ein zweites Ausführungsbeispiel einer erfindungsgemäßen Einrichtung E zur Residuenauswertung eines Residuums r zur Erkennung von Systemfehlern im Systemverhalten eines Systems S eines Flugzeuges.

Das zweite Ausführungsbeispiel gemäß Fig. 3 umfasst sämtliche Merkmale des ersten Ausführungsbeispiels gemäß Fig. 2, welche zur Vermeidung von Wiederholungen daher nicht erneut dargestellt werden.

Gemäß dem zweiten Ausführungsbeispiel der erfindungsgemäßen Einrichtung E ist die erste Einheit E1 dazu eingerichtet, den konstanten Schwellwertanteil s0 in Abhängigkeit eines zu erwartenden, inhärenten Messrauschens mr des Systems S bereitzustellen.

Dabei stellt die erste Einheit E1 den konstanten Schwellwert s0 vorzugsweise auf einen minimalen Wert.

Weiterhin ist gemäß Fig. 3 die zweite Einheit E2 dazu eingerichtet, den adaptiven Schwellwert s1 in Abhängigkeit der zeitveränderlichen Führungsgröße w, zumindest einer bereitgestellten Messgröße mg des Systems S und/oder einer mittels eines Systemmodells SM der Vorrichtung V geschätzten Zustandsgröße zg bereitzustellen.

Weiter weist die Einrichtung E vorzugsweise eine vierte Einheit E4 auf, welche dazu eingerichtet ist, die Komparator-Einheit KE nach Ablauf einer vorbestimmten Bestätigungszeit zu aktivieren. Hierzu steuert die vierte Einheit E4 die Komparator-Einheit KE vorzugsweise mittels eines Aktivierungssignals a.

Beispiele für die Vorrichtung V zur Residuengenerierung des Residuums r sind in den Figuren 4 und 5 dargestellt.

Dazu ist in Fig. 4 ein schematisches Blockschaltbild eines Ausführungsbeispiels der erfindungsgemäßen Vorrichtung V zur Residuengenerierung zur Erkennung von Systemfehlern, insbesondere von fehlerhaften Transienten, Drift oder Oszillationen, im Systemverhalten eines Systems S eines Flugzeugs dargestellt.

Die Vorrichtung V zur Residuengenerierung zur Erkennung von fehlerhaften Transienten, Drift oder Oszillationen im Systemverhalten eines Systems S eines Flugzeuges hat ein erstes Mittel 1, ein zweites Mittel 2, ein drittes Mittel 3 und ein viertes Mittel 4. Das erste bis vierte Mittel 1-4 bilden eine Störbeobachter-Einheit SB. Das System S empfängt eingangsseitig eine Führungsvorgabe w und eine Störgröße z, welche externe Störungen auf das System S abbildet. Abhängig davon stellt das System ausgangsseitig eine System-Ausgangsposition y bereit. Das System S ist beispielsweise ein elektrohydraulisches Ruderstellsystem des Flugzeuges, wobei dann die System-Ausgangsgröße y eine gemessene Verschiebung des Aktuatorkolbens des positionsgeregelten Ruderstellsystems S ist.

Das erste Mittel 1 hat ein System-Modell SM zur Abbildung des zu überwachenden Systems S. Das erste Mittel 1 empfängt eingangsseitig die Führungsgröße w, eine Beobachterrückführgröße b und eine Störmodellgröße z. Abhängig davon stellt das erste Mittel 1 ausgangsseitig eine geschätzte System-Ausgangsgröße $\hat{y}$ bereit (Fig. 4).

Das zweite Mittel 2 ist dazu eingerichtet, ein Residuum r aus der Differenz zwischen der System-Ausgangsgröße y und der geschätzten System-Ausgangsgröße $\hat{y}$ zu bilden. Das zweite Mittel 2 ist beispielsweise als ein Subtrahierer ausgebildet.

Das dritte Mittel 3 ist als eine Beobachter-Rückführung L ausgebildet. Das dritte Mittel 3 empfängt eingangsseitig das Residuum r und stellt in Abhängigkeit des empfangenen Residuums r ausgangsseitig die Beobachterrückführgröße bg zur dynamischen Korrektur des Systemmodells SM derart bereit, dass die geschätzte System-Ausgangsgröße $\hat{y}$ der System-Ausgangsgröße y folgt.

Des Weiteren ist das vierte Mittel 4 mit einem Störmodell ZM ausgestattet, welches eingangsseitig das Residuum r empfängt und abhängig davon ausgangsseitig die Störmodellgröße z zur Abbildung der Wirkungen oder Effekte der externen Störungen auf das System-Modell SM bereitstellt.

Die Beobachterrückführung L ist insbesondere zur dynamischen Korrektur der inneren Zustände des System-Modells SM derart eingestellt, dass die geschätzte System-Ausgangsgröße $\hat{y}$ der System-Ausgangsgröße y folgt, wobei ein Abklingen einer Anfangsstörung und ein Folgeverhalten der externen Störungen durch eine Gewichtung der Residuen r und eine Rückführung auf das Systemmodell SM bereitgestellt wird.

Fig. 5 zeigt ein zweites Ausführungsbeispiel einer erfindungsgemäßen Vorrichtung V zur Residuengenerierung eines Residuums r zur Erkennung von Systemfehlern, insbesondere von fehlerhaften Transienten, Drift oder Oszillationen, im Systemverhalten eines Systems S eines Flugzeuges.

Das zweite Ausführungsbeispiel gemäß Fig. 5 umfasst sämtliche Merkmale des ersten Ausführungsbeispiels gemäß Fig. 4, welche zur Vermeidung von Wiederholungen daher nicht erneut dargestellt werden.

Gemäß dem zweiten Ausführungsbeispiel der erfindungsgemäßen Vorrichtung V hat die Störbeobachter-Einheit SB eine Beobachterrückführmatrix L zur Ausbildung der Beobachterrückführung. Dabei werden die Koeffizienten der Beobachterrückführmatrix L über einen Zustandsreglerentwurf bestimmt. Der Zustandsreglerentwurf ist beispielsweise durch eine Polvorgabe, durch einen optimalen Reglerentwurf, durch ein Entwurfsverfahren zum Entwurf robuster Rückführungen, durch lineare quadratische Schätzer (LQE; Linear Quadratic Estimator) oder durch nicht lineare Ansätze ausgebildet.

Ferner ist die Störmodellgröße $\hat{z}$ oder geschätzte Störgröße $\hat{z}$ als eine dynamische Störmodellgröße $\hat{z}$ ausgebildet, welche mittels einer Linearkombination künstlicher Systemzustände gebildet wird.

Dabei wird die dynamische Störmodellgröße $\hat{z}$ vorzugsweise mittels einer Linearkombination einer Einregel-Matrix K, eines Integrators $\frac{1}{s}$ und einer Störgrößenmatrix F gebildet. Dabei empfängt die Einregel-Matrix K das Residuum r und die Störgrößen-Matrix F stellt ausgangsseitig die Störmodellgröße $\hat{z}$ bereit. Der Integrator $\frac{1}{s}$ ist zwischen der Einregel-Matrix K und der Störgrößen-Matrix F angeordnet. In Analogie zum verallgemeinerten Zustandsvektors x des realen Systems S, bezeichnet $\hat{x}$ die Systemzustände des linearen Systemmodells SM, welche sich durch Integration mittels des Integrators $\frac{1}{s}$ aus zeitlichen Änderungen der Systemzustände $\dot{\hat{x}}$ ergeben. Diese sind die Summe der Störmodellausgangsgröße $\hat{z}$, der Beobachterrückführgröße bg, einer über die Eingangsmatrix B gewichteten Führungsgröße w sowie der über die Systemmatrix A zurückgeführten Systemzustände $\hat{x}$. Eine Multiplikation der dynamischen Systemmodellzustände $\hat{x}$ mit der Ausgabematrix C ergibt die geschätzte System-Ausgangsgröße $\hat{y}$. $\hat{x}(0)$ beschreibt den Anfangswert des linearen Systemmodells SM.

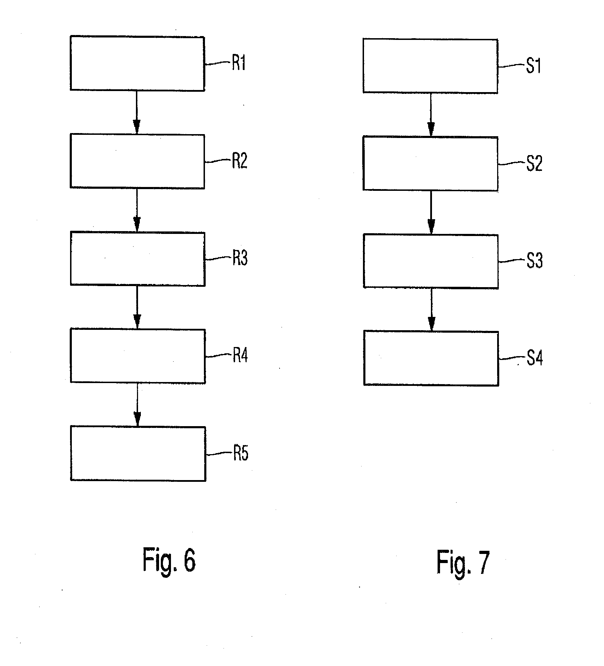

Fig. 6 zeigt ein schematisches Ablaufdiagramm eines Ausführungsbeispiels eines Verfahrens zur Residuenauswertung eines Residuums r zur Erkennung von Systemfehlern im Systemverhalten eines Systems S eines Flugzeugs.

Nachfolgend wird das erfindungsgemäße Verfahren anhand des Blockschaltbildes in Fig. 6 unter Verweis auf das Blockschaltbild in Fig. 2 beschrieben. Das Ausführungsbeispiel des erfindungsgemäßen Verfahrens gemäß Fig. 6 hat folgende Verfahrensschritte R1 bis R5:

Verfahrensschritt R1:

Ein Residuum r wird zumindest in Abhängigkeit der Führungsgröße w und der System-Ausgangsgröße y generiert.

Verfahrensschritt R2:

Ein konstanter Schwellwertanteil s0 wird bereitgestellt.

Verfahrensschritt R3:

Ein adaptiver Schwellwertanteil s1 wird zumindest in Abhängigkeit der zeitlich veränderlichen Führungsgröße w bereitgestellt.

Verfahrensschritt R4:

Ein Schwellwert s wird mittels einer Verknüpfung, insbesondere mittels einer Addition, des konstanten Schwellwertanteils s0 mit dem adaptiven Schwellwertanteil s1 bereitgestellt.

Verfahrensschritt R5:

Das Residuum r wird mit dem bereitgestellten Schwellwert s zur Bereitstellung eines Auswerte-Ergebnisses b verglichen. Liegt das Residuum r über dem bereitgestellten Schwellwert s, so ist ein Systemfehler des Systems S festgestellt.

Fig. 7 zeigt ein schematisches Ablaufdiagramm eines Ausführungsbeispiels des erfindungsgemäßen Verfahrens zur Residuengenerierung eines Residuums r zur Erkennung von Systemfehlern, insbesondere von fehlerhaften Transienten, Drift oder Oszillationen, im Systemverhalten eines Systems S eines Flugzeuges, welches eine Führungsgröße w und eine externe Störungen abbildende Störgröße z empfängt und ausgangsseitig eine System-Ausgangsgröße y bereitstellt.

Nachfolgend wird das erfindungsgemäße Verfahren anhand des Blockschaltbildes in Fig. 7 unter Verweis auf das Blockschaltbild in Fig. 4 beschrieben. Das Ausführungsbeispiel des erfindungsgemäßen Verfahrens gemäß Fig. 7 hat folgende Verfahrensschritte S1 bis S4:

Verfahrensschritt S1:

Ein Systemmodell SM zur Abbildung des zu überwachenden Systems S wird bereitgestellt. Das Systemmodell SM empfängt eingangsseitig die Führungsgröße w, eine Beobachterrückführgröße bg und eine Störmodellgröße $\hat{z}$. Abhängig davon stellt das Systemmodell SM ausgangsseitig eine geschätzte System-Ausgangsgröße $\hat{y}$ bereit.

Verfahrensschritt S2:

Ein Residuum r wird aus der Differenz zwischen der System-Ausgangsgröße y und der geschätzten System-Ausgangsgröße $\hat{y}$ gebildet.

Verfahrensschritt S3:

Eine Beobachter-Rückführung L wird bereitgestellt, welche eingangsseitig das Residuum r empfängt und abhängig davon ausgangsseitig die Beobachterrückführgröße bg zur dynamischen Korrektur des Systemmodells SM derart bereitstellt, dass die geschätzte System-Ausgangsgröße $\hat{y}$ der System-Ausgangsgröße y folgt.

Verfahrensschritt S4:

Ein Störmodell ZM wird bereitgestellt, welches eingangsseitig das Residuum r empfängt und abhängig davon ausgangsseitig die Störmodellgröße $\hat{z}$ zur Abbildung der Wirkungen oder Effekte der externen Störungen auf das Systemmodell SM bereitstellt.

Vorzugsweise wird bei festgestellter Verfügbarkeit einer weiteren Messgröße des Systems S die Menge der geschätzten Systemgrößen im System-Modell SM um diese erweiterte Messgröße reduziert und diese weitere Messgröße wird dem System-Modell SM als weitere Eingangsgröße direkt zugeführt.

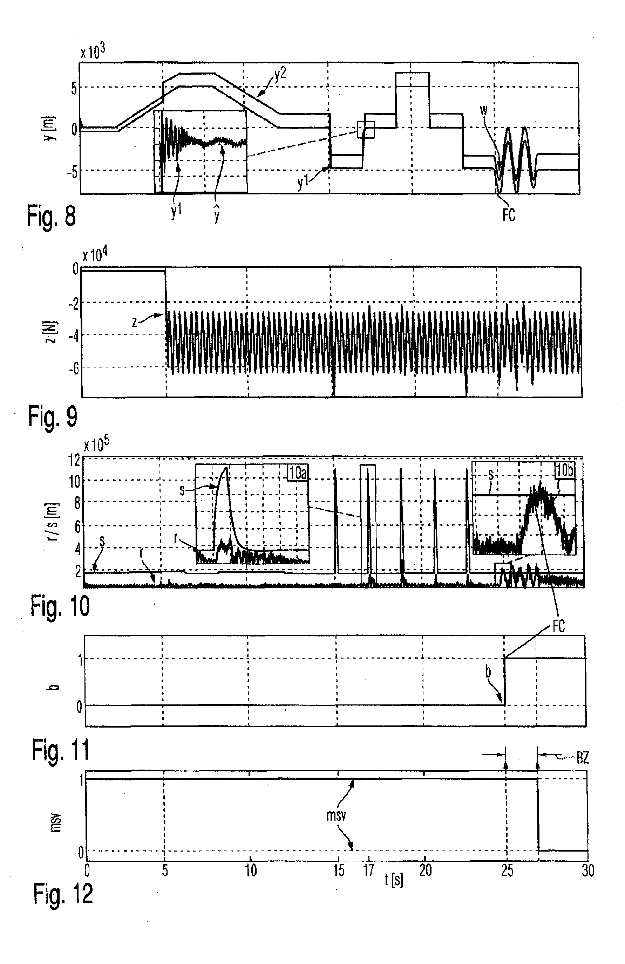

Die Figuren 8 bis 12 zeigen schematische Zeitdiagramme zur Illustrierung der erfindungsgemäßen Residuenauswertung eines Residuums r zur Erkennung von Systemfehlern FC im Systemverhalten eines Systems S eines Flugzeuges.

Dem Beispiel der Figuren 8 bis 12 liegt ein Ruderstellsystem als System S mit einem ersten Aktuator - bezeichnet durch die Verschiebung des Aktuatorkolbens des ersten Aktuators als das System-Ausgangssignal y1 - und einem redundanten zweiten Aktuator - bezeichnet durch die Verschiebung des Aktuatorkolbens des zweiten Aktuators als das System-Ausgangssignal y2 - zugrunde.

Dabei zeigt Figur 8 den zeitlichen Verlauf der System-Ausgangssignale y1 und y2. Weiter zeigt Figur 9 den zeitlichen Verlauf der Störung z. Figur 10 zeigt den zeitlichen Verlauf des Residuums r und des erfindungsgemäßen Schwellwertes s. Weiter zeigen die Figuren 11 den zeitlichen Verlauf des Auswerte-Ergebnisses b sowie den zeitlichen Verlauf eines Ansteuersignals msv, das in Abhängigkeit des Auswerte-Ergebnisses b zur Auswahl des Aktuators 1 oder 2 generiert wird.

Wie oben bereits ausgeführt, zeigt Figur 8 den zeitlichen Verlauf der System-Ausgangssignale y1 und y2. Zum Zeitpunkt t = 17 s steigen die System-Ausgangssignale y1 und y2 gemäß der Führungsvorgabe w deutlich an.

Weiter zeigt Figur 9 den zeitlichen Verlauf der Störung z, die einer Kraft entspricht, mit der die durch den Aktuator 1 bzw. 2 angetriebene Stellfläche des Flugzeuges belastet wird. Diese Kraft wird auch als aerodynamische Last oder Luftlast bezeichnet.

Weiterhin zeigt Figur 10 den zeitlichen Verlauf des Residuums r und des erfindungsgemäßen Schwellwertes s. Dabei zeigt Figur 10a eine detaillierte Darstellung der Figur 10 um den Zeitpunkt t = 17 s, bei dem nach Figur 8 die Führungsgröße w und damit die System-Ausgangsgrößen y1 und y2 sprungartig ansteigen. Gemäß der Erfindung wird der Schwellwert s in Abhängigkeit der Führungsvorgabe w angepasst, d.h. der Schwellwert s wird in Abhängigkeit des Springens der Führungsvorgabe w angepasst und wird deshalb selbst springen (siehe Fig. 10a). Damit wird zum Zeitpunkt t = 17 s gemäß Figur 11 kein Fehler detektiert, so dass b = 0 zum Zeitpunkt t = 17 s ist.

Zum Zeitpunkt t = 25 s tritt hingegen ein Systemfehler FC auf, der in einem Schwingen der System-Ausgangssignale y1 und y2 resultiert. Nachdem sich zu diesem Zeitpunkt t = 25 s die Führungsvorgabe w nicht ändert, wird auch der Schwellwert s nicht angepasst. Folglich wird zum Zeitpunkt t = 25 s das Residuum r den bereitgestellten Schwellenwert s übersteigen. Dies ist im Detail in Figur 10b dargestellt.

Folglich wird hier gemäß Figur 11 das Auswerteergebnis b von 0 auf 1 umschalten, d.h. zum Zeitpunkt t = 25 s ist b = 1.

Gemäß Figur 12 wird nach Ablauf einer Bestätigungszeit BZ, die beispielsweise 2 s beträgt, ein Ansteuersignal msv von 1 auf 0 umschalten. Diese Umschaltung indiziert, dass von dem ersten Aktuator auf den zweiten Aktuator umgeschaltet wird. Damit ist zum Zeitpunkt t = 27 s die Rekonfiguration und damit die Umschaltung des Systems S von dem ersten Aktuator auf den zweiten Aktuator abgeschlossen.

Erfindungsgemäß kann die Bestätigungszeit auch auf 0 gesetzt werden, da bereits zum Zeitpunkt t = 25 s feststeht, dass eine Umschaltung von dem Aktuator 1 auf den Aktuator 2 notwendig ist.

Obwohl die vorliegende Erfindung anhand bevorzugter Ausführungsbeispiele vorliegend beschrieben wurde, ist sie darauf nicht beschränkt, sondern auf vielfältige Weise modifizierbar.

**Bezugszeichenliste**

| | |
|---|---|
| 1 | erstes Mittel |
| 2 | zweites Mittel |
| 3 | drittes Mittel |
| 4 | viertes Mittel |
| a | Aktivierungssignal |
| BZ | Bestätigungszeit |
| b | Auswerte-Ergebnis |
| bg | Beobachterrückführgröße oder Ausgangssignal der Beobachterrückführung |
| A | Systemmatrix des linearen Systemmodells SM |
| B | Eingangsmatrix des linearen Systemmodells SM |
| C | Ausgabematrix des linearen Systemmodells SM |
| E1 | erste Einheit |
| E2 | zweite Einheit |
| E3 | dritte Einheit |
| E4 | vierte Einheit |
| F | Störgrößenmatrix |
| KE | Komparator-Einheit |
| K | Einregler-Matrix |
| L | Beobachterrückführmatrix |
| mg | Messgröße |
| mr | Messrauschen |
| R1-R5 | Verfahrensschritt |
| r | Residuum |
| S | System |
| S1-S4 | Verfahrensschritt |
| SB | Störbeobachter-Einheit |

SM      System-Modell
FC      Systemfehler
w      Führungsgröße
y      System-Ausgangsgröße
$\hat{y}$      geschätzte System-Ausgangsgröße
z      Störgröße
zg      Zustandsgröße
$\hat{z}$      Störmodellgröße
ZM      Störmodell

$\frac{1}{s}$      Integrator

**Patentansprüche**

1. Einrichtung (E) zur Residuenauswertung eines Residuums (r) zur Erkennung von Systemfehlern eines Systems (S), welches eine zeitlich veränderliche Führungsgröße (w) und eine externe Störungen abbildende Störgröße (z) eingangsseitig empfängt und ausgangsseitig eine System-Ausgangsgröße (y) bereitstellt, mit:

     a) einer Vorrichtung (V) zur Residuengenerierung des Residuums (r) zumindest in Abhängigkeit der Führungsgröße (w) und der System-Ausgangsgröße (y);
     b) einer Komparator-Einheit (K) zur Bereitstellung eines Auswerte-Ergebnisses (b) mittels eines Vergleichs des Residuums (r) mit einem bereitgestellten Schwellwert (s);
     c) einer ersten Einheit (E1) zur Bereitstellung eines konstanten Schwellwertanteils (s0);
     d) einer zweiten Einheit (E2) zur Bereitstellung eines adaptiven Schwellwertanteils (s1) zumindest in Abhängigkeit der zeitlich veränderlichen Führungsgröße (w); und
     e) einer dritten Einheit (E3) zur Bereitstellung des Schwellwertes (s) mittels einer Verknüpfung des konstanten Schwellwertanteils (s0) mit dem adaptiven Schwellwertanteil (s1).

2. Einrichtung nach Anspruch 1,
**dadurch gekennzeichnet,**
**dass** die erste Einheit (E1) dazu eingerichtet ist, den konstanten Schwellwertanteil (s0) in Abhängigkeit eines zu erwartenden, inhärenten Messrauschens (mr) des Systems (S) bereitzustellen.

3. Einrichtung nach Anspruch 2,
**dadurch gekennzeichnet,**
**dass** die erste Einheit (E1) dazu eingerichtet ist, den konstanten Schwellwertanteil (s0) in Abhängigkeit des zu erwartenden, inhärenten Messrauschens (mr) des Systems (S) auf einen minimalen Wert einzustellen.

4. Einrichtung nach einem der Ansprüche 1 bis 3,
**dadurch gekennzeichnet,**
**dass** die zweite Einheit (E2) dazu eingerichtet ist, den adaptiven Schwellwertanteil (s1) in Abhängigkeit der zeitveränderlichen Führungsgröße (w) und zumindest einer bereitgestellten Messgröße (mg) des Systems (S) bereitzustellen.

5. Einrichtung nach einem der Ansprüche 1 bis 4,
**dadurch gekennzeichnet,**
**dass** die Vorrichtung (V) zur Residuengenerierung des Residuums (r) zumindest ein Systemmodell (SM) zur Abbildung des zu überwachenden Systems (S) umfasst.

6. Einrichtung nach einem der Ansprüche 1 bis 5,
**dadurch gekennzeichnet,**
**dass** die Vorrichtung (V) zur Residuengenerierung des Residuum (r) aufweist:

     - ein erstes Mittel (1) mit einem System-Modell (SM) zur Abbildung des zu überwachenden Systems (S), welches eingangsseitig die Führungsgröße (w), eine Beobachterrückführgröße (b) und eine Störmodellgröße (z) empfängt und abhängig davon ausgangsseitig eine geschätzte System-Ausgangsgröße (y) bereitstellt;
     - ein zweites Mittel (2) zur Bildung eines Residuums (r) aus der Differenz zwischen der System-Ausgangsgröße (y) und der geschätzten System-Ausgangsgröße $(\hat{y})$ ;
     - ein drittes Mittel (3) mit einer Beobachter-Rückführung (L), welche eingangsseitig das Residuum (r) empfängt und abhängig davon ausgangsseitig die Beobachterrückführgröße (b) zur dynamischen Korrektur des System-Modells (SM) derart bereitstellt, dass die geschätzte System-Ausgangsgröße (y) der System-Ausgangsgröße (y) folgt; und
     - ein viertes Mittel (4) mit einem Störmodell (ZM), welches eingangsseitig das Residuum (r) empfängt und abhängig davon ausgangsseitig die Störmodellgröße (z) zur Abbildung der Wirkungen der externen Störungen auf das Systemmodell (SM) bereitstellt.

7. Einrichtung nach Anspruch 5 oder 6,
**dadurch gekennzeichnet,**
**dass** die zweite Einheit (E2) dazu eingerichtet ist, den adaptiven Schwellwertanteil (s1) in Abhängigkeit der zeitveränderlichen Führungsgröße (w) und zumindest einer mittels des Systemmodells (SM) geschätzten Zustandsgröße (zg) bereitzustellen.

8. Einrichtung nach einem der Ansprüche 5 bis 7,
**dadurch gekennzeichnet,**
**dass** die zweite Einheit (E2) dazu eingerichtet ist, den adaptiven Schwellwert (s1) in Abhängigkeit der zeitveränderlichen Führungsgröße (w) und zumindest einer bereitgestellten Messgröße (mg) des Systems (S) und/oder zumindest einer mittels des Systemmodells (SM) geschätzten Zustandsgröße (zg) bereitzustellen.

9. Einrichtung nach einem der Ansprüche 1 bis 8, **dadurch gekennzeichnet,** **dass** die dritte Einheit (E3) dazu eingerichtet ist, den konstanten Schwellwertanteil (s0) mit dem adaptiven Schwellwertanteil (s1) zur Bereitstellung des Schwellwertes (s) zu addieren.

10. Einrichtung nach einem der Ansprüche 1 bis 9, **dadurch gekennzeichnet,** **dass** die Komparator-Einheit (K) das Auswerte-Ergebnis (b) zur Anzeige eines Systemfehlers auf einen positiven logischen Wert setzt, falls das bereitgestellte Residuum (r) größer als der bereitgestellte Schwellwert (s) ist.

11. Einrichtung nach Anspruch 10, **dadurch gekennzeichnet,** **dass** eine vierte Einheit (E4) vorgesehen ist, welche die Komparator-Einheit (K) nach Ablauf einer vorbestimmten Bestätigungszeit aktiviert.

12. Einrichtung nach einem der Ansprüche 1 bis 11, **dadurch gekennzeichnet,** **dass** die Systemfehler fehlerhafte Transienten, Drift oder Oszillationen umfassen.

13. Flugzeug mit einer oder mehreren Einrichtungen (E) nach einem der Ansprüche 1 bis 12.

14. Verfahren zur Residuenauswertung eines Residuums (r) zur Erkennung von Systemfehlern im Systemverhalten eines Systems (S), welches eine zeitlich veränderliche Führungsgröße (w) und eine externe Störungen abbildende Störgröße (z) eingangsseitig empfängt und ausgangsseitig eine System-Ausgangsgröße (y) bereitstellt, mit den Schritten:

    a) Generieren eines Residuums (r) zumindest in Abhängigkeit der Führungsgröße (w) und der System-Ausgangsgröße (y);
    b) Bereitstellen eines konstanten Schwellwertanteils (s0) ;
    c) Bereitstellen eines adaptiven Schwellwertanteils (s1) zumindest in Abhängigkeit der zeitlich veränderlichen Führungsgröße (w);
    d) Bereitstellen eines Schwellwertes (s) mittels einer Verknüpfung des konstanten Schwellwertanteils (s0) mit dem adaptiven Schwellwertanteil (s1) ; und
    e) Vergleichen des Residuums (r) mit dem bereitgestellten Schwellwert (s) zur Bereitstellung eines Auswerte-Ergebnisses (b).

Fig. 1

Fig. 2

## Fig. 3

## Fig. 4

Fig. 5

Fig. 6

Fig. 7

Fig. 8

Fig. 9

Fig. 10

Fig. 11

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070124038 A1

**In der Beschreibung aufgeführte Nicht-Patentliteratur**

- **SACHS, HELGE.** Fault Investigation and Robust Failure Detection of Oscillatory Aircraft Actuation Systems Using Analytical Redundancy. *Hamburg, Hamburg University of Technology, Aircraft Systems Engineering M-7, PhD thesis*